# EUROPÄISCHE PATENTSCHRIFT

(11) **EP 3 552 004 B1**
(45) Veröffentlichungstag und Bekanntmachung des Hinweises auf die Patenterteilung: **11.03.2026**
(21) Anmeldenummer: 17808779.7
(22) Anmeldetag: 07.11.2017
(51) Int. Cl.: G01N 27/22, B32B 17/10, B60S 1/08

(54) **FENSTERSCHEIBE MIT KAPAZITIVEM SENSOR**
WINDOW PANE WITH CAPACITIVE SENSOR
VITRE DE FENÊTRE DOTÉE D'UN CAPTEUR CAPACITIF

(30) Priorität: 09.12.2016 EP 16203228
(43) Veröffentlichungstag der Anmeldung: 16.10.2019
(73) Patentinhaber: Saint-Gobain Sekurit France, 60150 Thourotte (FR)
(72) Erfinder: EFFERTZ, Christian, 52080 Aachen (DE); SCHMALBUCH, Klaus, 84220 Goult (FR); WEBER, Patrick, 52477 Alsdorf (DE); ESSER, Hans-Georg, 52064 Aachen (DE)
(74) Vertreter: Gebauer, Dieter Edmund
(86) Internationale Anmeldenummer: PCT/EP2017/078382
(87) Internationale Veröffentlichungsnummer: WO 2018/103975

(56) Entgegenhaltungen:
- WO-A1-2007/009973
- DE-A1- 102008 043 610
- US-A- 6 094 981
- US-A1- 2009 039 901
- US-B2- 8 009 053

## Beschreibung

Die Erfindung betrifft eine Verbundscheibe mit einem kapazitiven Sensor, ein Verfahren zur Herstellung der Verbundscheibe und deren Verwendung.

Windschutzscheiben von Kraftfahrzeugen sind häufig mit einer Vielzahl an Funktionen ausgestattet. Eine Windschutzscheibe ist üblicherweise eine Verbundscheibe, die eine Innenscheibe eine Außenscheibe und eine die beiden Scheiben flächig verbindende Zwischenschicht umfasst. Die Zwischenschicht enthält einen Kunststoff, z.B. Polyvinylbutyral (PVB), Ethylenvinylacetat (EVA) und/oder Polyethylenterephthalat (PET). Die Funktionen der Windschutzscheibe werden durch Sensoren gesteuert, z.B. auch einen Regensensor, der automatisch Regen auf der Windschutzscheibe detektiert. Der Regensensor dient dazu die Funktion der Scheibenwischer automatisch in Abhängigkeit von auf der Windschutzscheibe erfasstem Regen bzw. Feuchtigkeit zu steuern ohne dass der Fahrzeugführer eingreifen muss.

Die häufig verwendeten Regensensoren sind Lichtsensoren, die über ein Fotoelement zur Erfassung von Lichtstrahlen verfügen. Dabei wird Licht in einen Abschnitt der Windschutzscheibe eingekoppelt, das an der äußeren Oberfläche der Windschutzscheibe durch Totalreflexion reflektiert und zu dem Fotoelement geleitet wird. Das Fotoelement misst die Lichtstärke und stellt davon abhängig ein Meßsignal bereit. Durch eine Veränderung bzw. Verringerung des Meßsignals wird Regen auf der Windschutzscheibe erfasst und die Wischfunktion an der Windschutzscheibe ausgelöst. Ein derartiger Regensensor erfordert einen erheblichen Platzbedarf, insbesondere auf der Innenseite der Windschutzscheibe. Die einzelnen Komponenten des Regensensors reichen in den Innenbereich des Kraftfahrzeugs hinein.

Ferner sind Kondensatoren bekannt, die für Regensensoren verwendet werden. Diese Kondensatoren sind üblicherweise Streufeldkondensatoren, die auf einer Windschutzscheibe angeordnet sind und bei denen sich die Streufeldkapazität in Abhängigkeit des auf der Windschutzscheibe vorhandenen Regens ändert. Aus der DE 102009029079 A1 ist ein Streufeldkondensator bekannt, der eine zentral oder exzentrisch angeordnete Referenzelektrode und eine weitere Gegenelektrode aufweist. Beide Elektroden sind in einer gemeinsamen Elektrodenebene angeordnet, wobei die Gegenelektrode die Referenzelektrode umschließt und von dieser aber galvanisch getrennt ist. Zwischen der Referenzelektrode und mindestens einer Gegenelektrode wird ein elektrisches Feld erzeugt, welches in einen dielektrischen Raum außerhalb der Windschutzscheibe hineinreicht. Dazu sind die Elektroden jeweils mit einem Plus- bzw. einem Minuspol einer Versorgungsspannungsquelle verbunden. Durch den auf der Windschutzscheibe gefallenen Regen ändert sich das elektrische Feld und somit die Kapazität des Streufeldkondensators. Ein solcher Streufeldkondensator muss aufwendig auf der Windschutzscheibe aufgebracht werden, schränkt mit zunehmender Anzahl der Elektroden auf der Verbundscheibe die Durchsicht des Fahrzeugführers ein, und neigt zur Fehlermeldung bei der Detektion von Regen. Weiterhin kann ein derartiger Streufeldkondensator zwar die Anwesenheit des Regens melden, aber nicht die Intensität des Regens erfassen.

US 8009053 B2 und DE 102008043610 A1 offenbaren jeweils eine Verbundscheibe gemäß dem Oberbegriff von Patentanspruch 1. Kapazitive Regensensoren sind weiterhin aus WO 2007/009973 A1, US 2009/039901 A1 und US 6094981 A bekannt. Die Aufgabe der vorliegenden Erfindung besteht darin, eine verbesserte Verbundscheibe bereitzustellen, die einen Sensor aufweist, der einfach und kostengünstig in die Fensterscheibe integriert werden kann und ein hohes Maß an Zuverlässigkeit und Wirksamkeit besitzt.

Die Aufgabe der vorliegenden Erfindung wird erfindungsgemäß durch eine Verbundscheibe mit einem kapazitiven Sensor gemäß dem unabhängigen Patentanspruch 1, sowie durch ein Verfahren zur Herstellung der Verbundscheibe und deren Verwendung gemäß den Ansprüchen 8 und 9 gelöst. Bevorzugte Ausführungen gehen aus den Unteransprüchen hervor.

Die erfindungsgemäße Verbundscheibe weist die Merkmale gemäß Patentanspruch 1 auf.

Die Verbundscheibe ist zur Abtrennung eines Innenraums von einer äußeren Umgebung vorgesehen. Die erfindungsgemäße Verbundscheibe umfasst eine Innenscheibe und eine Außenscheibe. Mit Innenscheibe wird dabei diejenige Scheibe bezeichnet, welche in Einbaulage dem Innenraum des Fahrzeugs zugewandt ist. Die Verbundscheibe ist dafür vorgesehen, in einer Öffnung, insbesondere einer Fensteröffnung eines Fahrzeugs, den Innenraum gegenüber der äußeren Umgebung abzutrennen. Mit Außenscheibe wird diejenige Scheibe bezeichnet, welche in Einbaulage der äußeren Umgebung des Fahrzeugs zugewandt ist. Die Verbundscheibe kann vielfältig eingesetzt werden: Im Falle einer Verbundscheibe als Fahrzeugscheibe kann sie beispielsweise eine Dachscheibe, eine Windschutzscheibe, eine Heckscheibe, eine Seitenscheibe oder eine andere den Fahrzeuginnenraum begrenzende Verglasung sein. Außenseitige Oberfläche der Scheibe bedeutet hierbei die Oberfläche der Scheibe, die nach außen, also von dem Fahrzeuginnenraum weg weist. Innenseitige Oberfläche bedeutet demnach die Oberfläche der Scheibe, die zum Fahrzeuginnenraum hin weist.

Die Erfindung geht von dem Gedanken aus, dass ein an die Verbundscheibe angebaute Sensorelektronik viel Platz beansprucht und gleichzeitig sich störend auf die Durchsicht für einen Fahrzeugführer auswirkt. Durch die erfindungsgemäße Verbundscheibe mit einem Kondensator, der zwei aus einer transparenten, elektrisch leitfähigen Beschichtung ausgebildete Elektroden aufweist, kann der Kondensator in einer einfachen Weise in die Verbundscheibe integriert werden. Die Durchsicht durch die Verbundscheibe ist dadurch nicht beeinträchtigt und der Kondensator ist hierdurch einfacher und platzsparender an der Verbundscheibe platzierbar. Gerade bei modernen Fahrzeugen mit komplexen Windschutzscheiben ist eine platzsparende Integration der Sensorik besonders wichtig.

Die transparente, elektrisch leitfähige Beschichtung weist wärmereflektierende Eigenschaften auf. Eine derartige Beschichtung ist ein Schichtsystem, das eine funktionelle Schicht enthält. Die funktionelle Schicht besteht üblicherweise aus einem elektrisch leitfähigen Oxid (TCO), bevorzugt Indium-Zinnoxid (ITO), fluordotiertes Zinnoxid (SnO₂:F), antimon-dotiertes Zinnoxid (SnO₂:Sb), aluminiumdotiertes Zinkoxid (ZnO:Al) und/oder galliumdortiertes Zinkoxid (ZnO:Ga). Die Beschichtung ist elektrisch leitfähig und weist im sichtbaren Spektralbereich eine geringe Absorption und eine geringe Reflexion und daher eine hohe Transmission auf. Die Verbundscheibe kann zumindest teilweise oder vollflächig die transparente, elektrisch leitfähige Beschichtung auf einer innenseitigen oder außenseitigen Oberfläche der Innenscheibe, Außenscheibe, Zwischenschicht oder in der Zwischenschicht aufweisen, wobei der Kondensator und die Elektroden durch zumindest eine beschichtungsfreie Trennlinie aus der Beschichtung elektrisch abgetrennt sind.

Besonders vorteilhafte erfindungsgemäße Elektroden sind zur Generierung einer Sensorfläche auf der Verbundscheibe, insbesondere einer außenseitigen Oberfläche, vorgesehen, innerhalb derer die Feuchtigkeit auf der Verbundscheibe eine Kapazitätsänderung hervorruft. Zwischen zwei Elektroden des Kondensators wird ein elektrisches Feld erzeugt, welches in einen Raum oberhalb der Verbundscheibe hineinragt und die Sensorfläche definiert. Der Raum oberhalb der verbundscheibe kann Luft, Wasser oder sonstige Verschmutzung und Beläge umfassen. Durch die Anordnung der Sensorfläche auf der Verbundscheibe ist ein schnelles Ansprechen des Sensors gewährleistet. Die Sensorfläche kann im oberen Abschnitt der Verbundscheibe, bevorzug mittig angeordnet sein.

In einer vorteilhaften Ausgestaltung ist die Sensorelektronik zur Generierung eines Signals vorgesehen, wenn auf der Sensorfläche Feuchtigkeit, inklusive Regen, erfasst wird. Zweckmäßigerweise wird lediglich ein Scheibenwischersystem des Fahrzeugs ausgelöst, sofern die Sensorelektronik ein entsprechendes Signal generiert hat.

Der kapazitive Sensor kann einen oder mehrere Kondensatoren, insbesondere 2ⁿ und maximal 32 Kondensatoren, aufweisen, wobei die Sensorelektronik zur Generierung mehrerer Signale vorgesehen ist und Mittel zur Berechnung einer Korrelation der Signale aufweist. Dadurch kann die Sensorelektronik zuverlässig bestimmen, ob Regen auf der Verbundscheibe vorhanden ist oder nicht. Diese Berechnung der Korrelation der Signale ist für Anwendungsfälle sinnvoll, bei denen es darum geht, innerhalb kurzer Zeit ein aussagekräftiges Signal für die Auslösung des Scheibenwischersystems zu bekommen. Dies ist der Fall, wenn während der Fahrt einsetzender Regen die Sicht des Fahrzeugführers stört und das Scheibenwischsystem schnell und zuverlässig ansprechen sollte. Somit lässt sich der normale Betriebsfall vom Regen unterscheiden.

Die Mittel der Sensorelektronik sind zur Berechnung einer Autokorrelation und/oder Kreuzkorrelation der Signale vorgesehen. Eine weitere Verbesserung der Verbundscheibe mit kapazitivem Sensor besteht darin, dass die Berechnung der Autokorrelation ein Ergebnis liefert, aus dem hervorgeht, ob Regen auf der Verbundscheibe vorhanden ist oder nicht. Ist das Ergebnis der Autokorrelation größer als 1, dann ist Regen auf der Verbundscheibe vorhanden. Anhand dieser Entscheidung wird die Funktion der Scheibenwischer ausgelöst. Anhand der Kreuzkorrelation kann in einfacher Art und Weise und mit geringem technischem Aufwand das Vorhandensein von Regen verifiziert werden, und somit die Resistenz gegenüber verschmutzungsbedingten Störungen erhöht werden. Das mathematische Verfahren der Kreuzkorrelation bestimmt hierbei die Ähnlichkeit zweier Signale, wenn diese um einen bestimmten Betrag zeitlich verschoben sind.

In einer weiteren vorteilhaften Ausführungsform der Erfindung sind die Elektroden unsymmetrisch ausgebildet. Durch die unsymmetrische Ausbildung der Elektroden werden unerwünschten Interferenzen mit elektromagnetischen Feldern, die durch benachbarte elektrische Leiter und Geräte erzeugt werden, vermieden.

Um die elektromagnetische Verträglichkeit des Sensors weiter zu verbessern, weisen die Elektroden einen unterschiedlichen Flächenumfang auf.

Eine kammförmige Elektrode weist einen längs gestreckten Kammrücken auf, auf dem eine Vielzahl an Kammzähnen angeordnet ist. Dabei verlaufen die Kammzähne zueinander parallel, wobei sie senkrecht auf dem Kammrücken angeordnet sind, sodass eine kammförmige gezahnte Elektrode entsteht. Überraschenderweise wurde festgestellt, dass eine derartige Ausbildung der zumindest einen Elektrode nahezu keine Fehlsignal, d.h. die Sensorelektronik generiert ein Schaltsignal, obwohl kein Regen auf der Windschutzscheibe vorhanden ist, liefert.

Mit gleichem Vorteil sind zwei kammförmige ausgebildete Elektroden ineinandergreifend ausgebildet. Wie die Zähne zweier Kämme greifen die Elektrodenflächen ineinander, sind aber weiterhin durch eine Trennlinie voneinander isoliert. Das elektrische Feld zwischen den Kammzähnen der kammförmigen Elektroden weist abschnittsweise nahezu parallele Feldlinien auf.

Außerdem hat es sich als vorteilhaft erwiesen, dass zwei kammförmige ausgebildete Elektroden Kammrücken an Kammrücken angeordnet sind.

Die Verbundscheibe kann eine Windschutzscheibe eines Fahrzeugs sein, bei der die Elektroden auf der zur Zwischenschicht hingewandten Oberfläche der Außenscheibe oder der Innenscheibe angeordnet sind. Alternativ oder zusätzlich können die Elektroden auf oder in der Zwischenschicht angeordnet sein. Die Elektroden erstrecken sich in einer gemeinsamen Ebene der Verbundscheibe, insbesondere in einer zu außenseitigen Oberfläche der Außenscheibe parallelen Ebene. Dadurch bildet sich ein elektrisches Feld zwischen mindestens zwei Elektroden aus, das das Regenwasser auf der Verbundscheibe durchdringt.

In einer möglichen Ausführungsform kann die Windschutzscheibe ergänzende Elektroden in unterschiedlichen Ebenen der Windschutzscheibe aufweisen, die dazu dienen, die Präzision der Messung zu erhöhen und z.B. Temperatureffekte wie einen Drift der Kapazität durch Änderung der Temperatur des Glases und des PVBs zu kompensieren. Dadurch, dass diese Kompensationselektroden in einer anderen Ebene liegen (bevorzugt weiter weg von der Fahrzeugaußenseite), ist der Effekt von Regen auf diese Strukturen schwächer, während sich Temperaturänderungen, insbesondere während der Standzeit des Fahrzeuges, auch auf diese Sensorstrukturen auswirken können.

Die Verbundscheibe kann einen oder mehrere kapazitive Sensoren zur Erfassung von Feuchtigkeit, vorzugsweise Regen, aufweisen. Die Sensoren können entlang eines Rands eines Wischfelds der Verbundscheibe angeordnet sein.

Die Zwischenschicht ist bevorzugt transparent. Die Zwischenschicht enthält vorzugsweise mindestens einen Kunststoff, bevorzugt Polyvinylbutyral (PVB), Ethylenvinylacetat (EVA) und/oder Polyethylenterephthalat (PET). Die Zwischenschicht kann aber auch beispielsweise Polyurethan (PU), Polypropylen (PP), Polyacrylat, Polyethylen (PE), Polycarbonat (PC), Polymethylmetacrylat, Polyvinylchlorid, Polyacetatharz, Gießharze, Acrylate, fluorinierte Ethylen-Propylene, Polyvinylfluorid und/oder Ethylen-Tetrafluorethylen, oder Copolymere oder Gemische davon enthalten. Die Zwischenschicht kann durch eine oder auch durch mehrere übereinander angeordnete Folien ausgebildet werden. Die Zwischenschichten können bevorzugt thermoplastisch sein und nach der Lamination die Innenscheibe, die Außenscheibe und eventuelle weitere Zwischenschichten miteinander verkleben.

Ein weiterer Aspekt der Erfindung umfasst ein Verfahren nach Anspruch 8.

Das Aufbringen der transparenten, elektrisch leitfähigen Beschichtung kann durch an sich bekannte Verfahren erfolgen, bevorzugt durch magnetfeldunterstützte Kathodenzerstäubung. Das ist besonders vorteilhaft im Hinblick auf eine einfache, schnelle, kostengünstige und gleichmäßige Beschichtung der Scheiben. Die transparente, elektrisch leitfähige Beschichtung kann aber auch beispielsweise durch Aufdampfen, chemische Gasphasenabscheidung (chemical vapour deposition, CVD), plasmagestützte Gasphasenabscheidung (PECVD) oder durch nasschemische Verfahren aufgebracht werden.

Die Entschichtung einzelner Trennlinien in der transparenten, elektrisch leitfähigen Beschichtung erfolgt vorzugsweise durch einen Laserstrahl. Verfahren zum Strukturieren dünner Metallfilme sind beispielsweise aus EP 2200097 A1 oder EP 2139049 A1 bekannt. Die Breite der Entschichtung beträgt bevorzugt 10 µm bis 1000 µm, besonders bevorzugt 30 µm bis 200 µm und insbesondere 70 µm bis 140 µm. In diesem Bereich findet eine besonders saubere und rückstandsfreie Entschichtung durch den Laserstrahl statt. Die Entschichtung mittels Laserstrahl ist besonders vorteilhaft, da die entschichteten Linien optisch sehr unauffällig sind und das Erscheinungsbild und die Durchsicht nur wenig beeinträchtigen. Die Entschichtung einer Linie mit einer Breite, die breiter ist als die Breite eines Laserschnitts, erfolgt durch mehrmaliges Abfahren der Linie mit dem Laserstrahl. Die Prozessdauer und die Prozesskosten steigen deshalb mit zunehmender Linienbreite an. Alternativ kann die Entschichtung durch mechanisches Abtragen sowie durch chemisches oder physikalisches Ätzen erfolgen.

Das Laminieren, also das Verbinden von Innenscheibe, Zwischenschicht und Außenscheibe, erfolgt bevorzugt unter Einwirkung von Hitze, Vakuum und/oder Druck. Es können an sich bekannte Verfahren zur Herstellung einer Verbundscheibe verwendet werden.

So können beispielsweise sogenannte Autoklavverfahren bei einem erhöhten Druck von etwa 10 bar bis 15 bar und Temperaturen von 130 °C bis 145 °C über etwa 2 Stunden durchgeführt werden. An sich bekannte Vakuumsack- oder Vakuumringverfahren arbeiten beispielsweise bei etwa 200 mbar und 80 °C bis 110 °C. Die Innenscheibe, die beispielsweise thermoplastische Zwischenschicht und die Außenscheibe können auch in einem Kalander zwischen mindestens einem Walzenpaar zu einer Scheibe verpresst werden. Anlagen dieser Art sind zur Herstellung von Scheiben bekannt und verfügen normalerweise über mindestens einen Heiztunnel vor einem Presswerk. Die Temperatur während des Pressvorgangs beträgt beispielsweise von 40 °C bis 150 °C. Kombinationen von Kalander- und Autoklavverfahren haben sich in der Praxis besonders bewährt. Alternativ können Vakuumlaminatoren eingesetzt werden. Diese bestehen aus einer oder mehreren beheizbaren und evakuierbaren Kammern, in denen die Innenscheibe und die Außenscheibe innerhalb von beispielsweise etwa 60 Minuten bei verminderten Drücken von 0,01 mbar bis 800 mbar und Temperaturen von 80°C bis 170°C laminiert werden.

In dem erfindungsgemäßen Verfahren kann als weiterer Verfahrensschritt die galvanische Kontaktierung der transparenten, elektrisch leitfähigen Beschichtung durch eine elektrische Leitungsverbindung erfolgen. Die galvanische Kontaktierung erfolgt bevorzugt mittels Kleben mit einem elektrisch leitfähigen Klebstoff, Löten und insbesondere Ultraschall-Löten.

Beim galvanischen Kontaktieren kann es vorteilhaft sein, wenn zunächst eine elektrisch leitfähige Kontaktschicht auf die transparente, elektrisch leitfähige Beschichtung aufgebracht wird, beispielsweise durch eine Metallisierung oder durch Drucken mittels einer metallhaltigen Siebdruckpaste und nachfolgendem Einbrennen. Diese Kontaktschicht ist besonders vorteilhaft, um eine niederohmige und korrosionsstabile Kontaktierung zwischen den leitfähigen Bestandteilen der transparenten, elektrisch leitfähigen Beschichtung und den weiteren Anschlusselementen wie Folienleiter oder Rundleiter zu erzielen.

Ein weiterer Aspekt der Erfindung umfasst die Verwendung der erfindungsgemäßen Verbundscheibe mit kapazitivem Sensor zur Erfassung von Feuchtigkeit in Fortbewegungsmitteln für den Verkehr auf dem Lande, in der Luft oder zu Wasser, insbesondere in Kraftfahrzeugen beispielsweise als Windschutzscheibe oder Heckscheibe.

Im Folgenden wird die Erfindung anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein.

Es zeigen:
- Figur 1: eine schematische Draufsicht auf eine Ausgestaltung einer erfindungsgemäßen Verbundscheibe mit einem kapazitiven Sensor,
- Figur 2: eine Querschnittsdarstellung entlang der Schnittlinie A-A' aus Figur 1,
- Figur 3: eine vergrößerte Darstellung des Ausschnitts Z aus Figur 1,
- Figur 4: eine erste alternative Darstellung des Ausschnitts Z aus Figur 1,
- Figur 5: eine zweite alternative Darstellung des Ausschnitts Z aus Figur 1,
- Figur 6: eine dritte alternative Darstellung des Ausschnitts Z aus Figur 1, welche in den Patentansprüchen nicht beansprucht ist, und
- Figur 7: eine vierte alternative Darstellung des Ausschnitts Z aus Figur 1, welche in den Patentansprüchen nicht beansprucht ist.

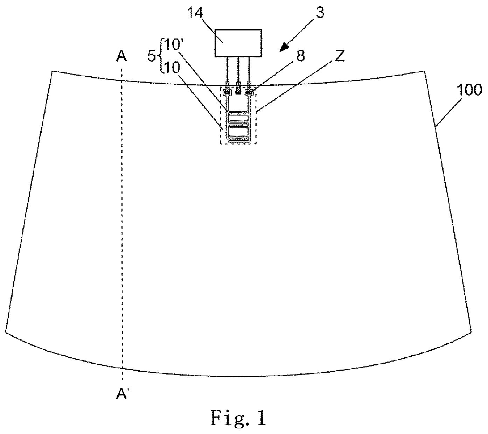

Figur 1 zeigt eine Draufsicht auf eine erfindungsgemäße Verbundscheibe 100 am Beispiel einer Windschutzscheibe eines Fahrzeugs. Die Verbundscheibe 100 verfügt im oberen Abschnitt der Verbundscheibe 100 über einen kapazitiven Sensor 3 zur Erfassung von Feuchtigkeit auf der Verbundscheibe 100. Im Sinne der Erfindung kennzeichnet der Ausdruck Feuchtigkeit das Maß der Anwesenheit von Wasser auf der Verbundscheibe 100 und beinhaltet auch Wasser in Form von Regen. Der kapazitive Sensor 3 misst eine durch die Feuchtigkeit bzw. Regen versursachte Änderung der Dielektrizitätszahl bzw. Kapazität. Hierzu weist der kapazitive Sensor 3 mindestens einen Kondensator 5 auf, der mit einer außerhalb der Verbundscheibe 100 angeordneten Sensorelektronik 14 über einen Anschluss 8 verbunden ist.

Der Anschluss 8 ist am äußeren Rand der Verbundscheibe 100 angeordnet. Dabei beträgt der Abstand zum äußeren Rand weniger als 10 cm, vorzugsweise ca. 0,5 cm. Dies erlaubt es eine elektrische Kontaktierung des Anschlusses, beispielsweise mit einem Folienleiter, unter einem optisch unauffälligen Schwarzdruck oder mit einer Abdeckung, beispielsweise einem Kameragehäuse, zu kaschieren.

Weiterhin umfasst der Kondensator 5 drei Elektroden 10, 10', 10", die jeweils galvanisch voneinander getrennt sind. Die Elektroden 10, 10', 10" sind in einer gemeinsamen Ebene angeordnet und kapazitiv miteinander gekoppelt. Die Elektroden generieren eine Sensorfläche auf einer außenseitigen Oberfläche I der Verbundscheibe, innerhalb derer die Feuchtigkeit auf der Verbundscheibe eine Kapazitätsänderung hervorruft.

Die Sensorelektronik ist dazu vorgesehen, eine Kapazitätsänderung zu messen und in Abhängigkeit eines gemessenen Wertes ein Schaltsignal an ein Scheibenwischersystem zu leiten. Hierzu verfügt der kapazitive Sensor über mehrere Kondensatoren 5. Die Sensorelektronik 14 ist mit einem Mikroprozessor ausgestattet, der zur Auswertung der von den Kondensatoren 5 übermittelten Werte eine Kreuzkorrelation und/oder eine Autokorrelation der Signale berechnet. Die Berechnung der Kreuzkorrelation und/oder der Autokorrelation wird kontinuierlich bestimmt und überwacht. In Abhängigkeit eines Schwellwerts wird das Schaltsignal über ein CAN-Bus des Fahrzeugs an das Scheibenwischersystem weitergeleitet.

Die ausgegebenen Schaltsignale können beliebig und den Erfordernissen der jeweiligen Verwendung angepasst sein. So kann das Schaltsignal eine positive Spannung, beispielsweise 12 V, bedeuten, kein Schaltsignal beispielsweise 0 V bedeuten und ein anderes Schaltsignal beispielweise + 6 V bedeuten. Die Schaltsignale können auch den bei einem CAN-Bus üblichen Spannungen CAN_High und CAN_Low entsprechen und um einen dazwischen liegenden Spannungswert wechseln. Das Schaltsignal kann auch gepulst und/oder digital codiert sein.

Bei der Autokorrelation der Signale wird ein Sensormesswert eines Kondensators mit dem Sensormesswert desselben Kondensators zu einem früheren Zeitpunkt korreliert. Wenn ein berechneter Autokorrelationskoeffizient größer ist als der vordefinierte Schwellwert, dann wird eine Kreuzkorrelation zweier Signale, ermittelt. Die zwei Signale umfassen mindestens ein erstes Signal, das einem Sensormesswert eines ersten Kondensators entspricht, und ein zweites Signal, das einem Sensormesswert eines zweiten Kondensators zum gleichen Zeitpunkt entspricht. Das erste Signal wird mit dem zweiten Signal kreuzkorreliert. Ist das Ergebnis der Kreuzkorrelation größer als ein zweiter Schwellwert und ungleich Eins, dann wird von dem Vorhandensein von Regen auf der Verbundscheibe ausgegangen und ein entsprechendes Schaltsignal, das die Funktion der Scheibenwischer steuert, an das Scheibenwischersystem übermittelt.

Falls das Ergebnis der Kreuzkorrelation einer Eins entspricht, wird die Anwesenheit von Regen auf der Verbundscheibe 100 verneint und kein Schaltsignal generiert.

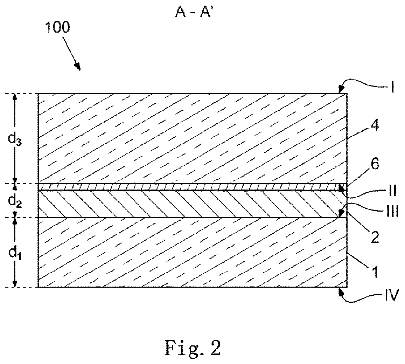

Figur 2 stellt einen Querschnitt entlang der Schnittlinie A-A' senkrecht zur gemeinsamen Ebene der Elektroden aus Figur 1 dar. Die Verbundscheibe 100 umfasst zumindest eine Innenscheibe 1, eine Zwischenschicht 2 und eine Außenscheibe 4. Nach der Endmontage in einer Einbaulage trennt die Verbundscheibe 100 einen Fahrzeuginnenraum von einer äußeren Umgebung ab. Dabei ist die innenseitige Oberfläche IV der Innenscheibe 1 vom Innenraum und die außenseitige Oberfläche I der Außenscheibe 4 von der äußeren Umgebung des Fahrzeugs her zugänglich. Weiterhin verfügt die Außenscheibe 4 über eine innenseitige Oberfläche II und die Innenscheibe 1 über eine außenseitige Oberfläche III.

Die Innenscheibe 1 und die Außenscheibe 4 bestehen beispielsweise aus Natron-Kalkglas und wurden im Floatverfahren hergestellt. Die Dicke d1 der Innenscheibe 1 beträgt beispielsweise 2,1 mm. Prinzipiell können die Scheiben 1 und 4 auch andere Dicken aufweisen.

Die Zwischenschicht 2 kann durch eine oder auch durch mehrere übereinander angeordnete Folien ausgebildet werden, wobei die Dicke einer Folie bevorzugt von 0,025 mm bis 3 mm beträgt, typischerweise 0,38 mm oder 0,76 mm. Die Zwischenschichten können bevorzugt thermoplastisch sein und nach der Lamination die Innenscheibe, die Außenscheibe und eventuelle weitere Zwischenschichten miteinander verkleben. Die Zwischenschicht 2 ist eine thermoplastische Zwischenschicht und besteht beispielsweise aus Polyvinylbutyral (PVB). Sie weist eine Dicke d2 von beispielsweise 0,76 mm auf.

Die Außenscheibe 4 weist auf ihrer innenseitigen Oberfläche II eine transparente, elektrisch leitfähige Beschichtung 6 auf. In Tabelle 1 sind drei Beispiele für transparente, elektrisch leitfähige Beschichtungen 6 mit funktionellen Schichten aus beispielsweise ITO dargestellt. Jede Beschichtung 6 der Beispiele 1-3 besteht aus einem Schichtstapel aus: Außenscheibe 1 / Haftschicht / funktioneller Schicht / Barriereschicht / Antireflexionsschicht. Die Dicke d₃ der Außenscheibe 4 beträgt beispielsweise ebenfalls 2,1 mm.

**Tabelle 1**

| | Material | Dicke | | |
|---|---|---|---|---|
| | | Beispiel 1 | Beispiel 2 | Beispiel 3 |
| Antireflexionsschicht | SiO₂:Al | 45 nm | 40 nm | 80 nm |
| Barriereschicht | Si₃N₄:Al | 12 nm | 20 nm | 12 nm |
| Funktionelle Schicht | ITO | 120 nm | 120 nm | 120 nm |
| Haftschicht | SiO₂:Al | 30 nm | 30 nm | 40 nm |
| Außenscheibe 4 bzw. Innenscheibe 1 | Kalk-Natronglas | | | |

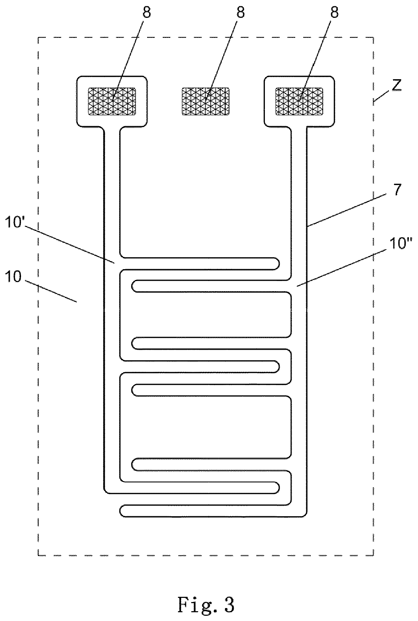

Figur 3 zeigt eine vergrößerte Darstellung des Ausschnitts Z der Verbundscheibe 100 aus Figur 1 mit den kapazitiv gekoppelten Elektroden 10, 10', 10". Die transparente, elektrisch leitfähige Beschichtung 6 ist durch eine beschichtungsfreie Trennlinie 7 in unterschiedliche, voneinander elektrisch isolierte Elektroden 10 unterteilt. In diesem Beispiel bedeutet elektrisch isoliert, dass die Bereiche voneinander galvanisch getrennt sind, das heißt, dass kein Gleichstrom (DC) zwischen den Bereichen fließen kann.

In dem in Figur 3 dargestellten Beispiel sind zwei Elektroden 10' und 10" von einer weiteren, dritten Elektrode 10 elektrisch unterteilt. Jede Elektrode 10' und 10" ist kammförmig ausgebildet und besteht aus einem Kammrücken und mehreren ineinandergreifenden Kammzähnen. Die Breite eines Kammzahns und des Kammrückens beträgt jeweils in diesem Beispiel etwa 1 mm. Der Kammrücken ist mit einem Anschluss 8 verbunden. Der Anschluss 8 hat eine rechteckige Form mit einer Breite von beispielsweise 12 mm. Die Länge des Kammrückens beträgt etwa 48 mm. Die dritte Elektrode 10 ist wiederum durch eine Trennlinie 7 von der restlichen transparenten, elektrisch leitfähigen Beschichtung 6 abgetrennt. Die dritte Elektrode 10 ist hier rechteckig ausgestaltet und umfasst beide Elektroden 10' und 10". Die dritte Elektrode 10 weist einen weiteren Anschluss 8 auf. Der weitere Anschluss 8 kann beliebig innerhalb der dritten Elektrode 10 angeordnet sein. Im dargestellten Beispiel ist er am oberen Rand der dritten Elektrode 10 am oberen Rand der Verbundscheibe 100 angeordnet. Er ist dadurch optisch unauffällig.

Die Trennlinie 7 hat lediglich eine Breite von beispielsweise 100 µm und ist durch Laserstrukturierung in die transparente, elektrisch leitfähige Beschichtung 6 eingebracht. Trennlinien 7 mit einer derart geringen Breite sind optisch kaum wahrnehmbar und stören die Durchsicht durch die Verbundscheibe 100 kaum, was besonders ästhetisch ist und besonders für eine Verwendung im Sichtbereich von Fahrzeugen von besonderer Wichtigkeit für die Fahrsicherheit ist.

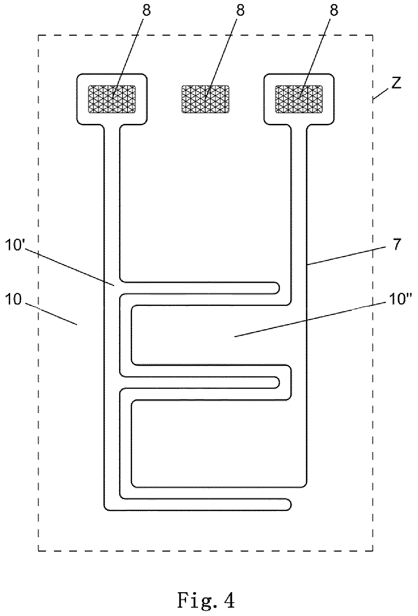

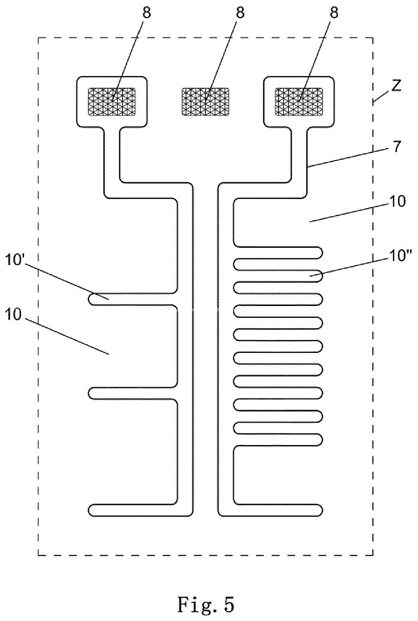

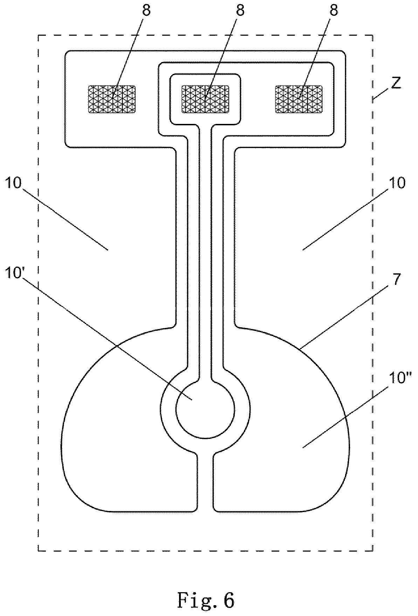

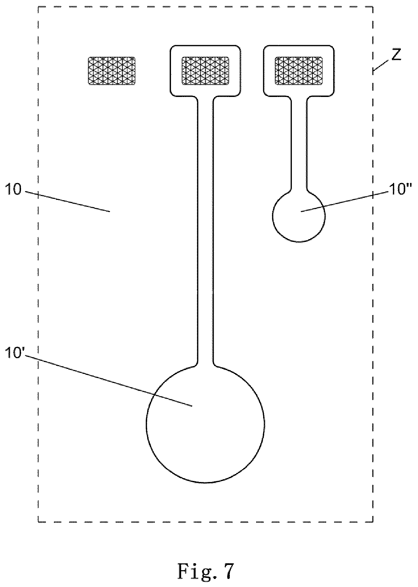

Figur 4 bis 7 zeigen alternative Darstellungen des Ausschnitts Z aus Figur 1. In Figur 4 und 5 sind alternative Formen der kammförmigen Elektroden 10' und 10" dargestellt. Figur 6 und 7 zeigen tulpenförmige Ausgestaltungen der Elektroden 10' und 10", welche in den Patentansprüchen nicht beansprucht sind.

### Bezugszeichenliste:

- 1: Innenscheibe
- 2: Zwischenschicht
- 3: kapazitiver Sensor
- 4: Außenscheibe
- 5: Kondensator
- 6: transparente, elektrisch leitfähige Beschichtung
- 7: Trennlinie
- 8: Anschluss
- 14: Sensorelektronik
- 100: Verbundscheibe

- d₁,d₂,d₃: Dicke

- A-A': Schnittlinie
- Z: Ausschnitt

- I: außenseitige Oberfläche der Außenscheibe 4
- II: innenseitige Oberfläche der Außenscheibe 4
- III: außenseitige Oberfläche der Innenscheibe 1
- IV: innenseitige Oberfläche der Innenscheibe 1

## Patentansprüche

1. Verbundscheibe (100) zur Abtrennung eines Innenraums von einer äußeren Umgebung, umfassend
- eine Innenscheibe (1), mit einer außenseitigen Oberfläche (III) und einer innenseitigen Oberfläche (IV),
- eine Außenscheibe (4), mit einer außenseitigen Oberfläche (I) und einer innenseitigen Oberfläche (II) und
- eine Zwischenschicht (2), die die innenseitige Oberfläche (II) der Außenscheibe (2) flächig mit der außenseitigen Oberfläche (III) der Innenscheibe (1) verbindet,
- eine im sichtbaren Spektralbereich transparente, elektrisch leitfähige Beschichtung (6) zumindest teilweise oder vollflächig auf einer innenseitigen oder außenseitigen Oberfläche der Innenscheibe (1), Außenscheibe (4), Zwischenschicht (2) oder in der Zwischenschicht (2),
- einen kapazitiven Sensor (3) zur Erfassung von Feuchtigkeit mit mindestens einem Kondensator (5), der mit einer Sensorelektronik (14) verbunden ist, die zur Erfassung einer Kapazitätsänderung des Kondensators (5) vorgesehen ist,
wobei der mindestens eine Kondensator (5) drei aus der transparenten, elektrisch leitfähigen Beschichtung (6) ausgebildete Elektroden (10, 10', 10") aufweist, die kapazitiv gekoppelt sind,
wobei die Elektroden (10, 10', 10") sich in einer gemeinsamen Ebene der Verbundscheibe (100) erstrecken und die transparente, elektrisch leitfähige Beschichtung (6) durch zwei beschichtungsfreie Trennlinien (7) in die voneinander elektrisch isolierten Elektroden (10, 10', 10") unterteilt ist, wobei zwei kammförmig ausgebildete Elektroden (10', 10") ineinandergreifen oder zwei kammförmig ausgebildete Elektroden (10', 10") Kammrücken an Kammrücken angeordnet sind, und
wobei die zwei kammförmig ausgebildeten Elektroden (10', 10") von einer dritten Elektrode (10) elektrisch unterteilt sind, wobei die dritte Elektrode (10) die beiden kammförmig ausgebildeten Elektroden (10', 10") umfasst und durch eine weitere Trennlinie (Z) von der restlichen transparenten, elektrisch leitfähigen Beschichtung (6) abgetrennt ist.

2. Verbundscheibe (100) nach Anspruch 1, **dadurch gekennzeichnet, dass** die Elektroden (10, 10', 10") zur Generierung einer Sensorfläche auf der Verbundscheibe vorgesehen sind, innerhalb derer die Feuchtigkeit auf der Verbundscheibe eine Kapazitätsänderung hervorruft.

3. Verbundscheibe (100) nach Anspruch 2, **dadurch gekennzeichnet, dass** die Sensorelektronik (14) zur Generierung eines Signals vorgesehen ist, wenn auf der Sensorfläche Feuchtigkeit erfasst wird.

4. Verbundscheibe (100) nach einem der Ansprüche 1 bis 3, **dadurch gekennzeichnet, dass** der kapazitive Sensor (3) mehrere Kondensatoren (5) umfasst, wobei die Sensorelektronik (14) zur Generierung mehrerer Signale vorgesehen ist und Mittel zur Berechnung einer Korrelation der Signale aufweist.

5. Verbundscheibe (100) nach Anspruch 4, **dadurch gekennzeichnet, dass** die Mittel des Sensors (3) zur Berechnung einer Autokorrelation und/oder Kreuzkorrelation der Signale vorgesehen sind.

6. Verbundscheibe (100) nach einem der Ansprüche 1 bis 5, **dadurch gekennzeichnet, dass** die Elektroden (10, 10', 10") eine unsymmetrische Fläche aufweisen.

7. Verbundscheibe (100) nach einem der Ansprüche 1 bis 6, **dadurch gekennzeichnet, dass** die Elektroden (10, 10', 10") einen unterschiedlichen Umfang aufweisen.

8. Verfahren zur Herstellung einer Verbundscheibe (100) nach einem der Ansprüche 1 bis 7, mindestens umfassend:
- Aufbringen einer transparenten, elektrisch leitfähige Beschichtung (6) zumindest teilweise oder vollflächig auf einer innenseitigen oder außenseitigen Oberfläche der Innenscheibe (1), Außenscheibe (4), Zwischenschicht (2) oder in der Zwischenschicht (2) und Einbringen von zwei Trennlinien (7), die die transparente, elektrisch leitfähige Beschichtung (6) in drei kapazitiv gekoppelte Elektroden (10, 10', 10") elektrisch unterteilt, bevorzugt durch Laserstrukturierung oder durch mechanisches oder chemisches Abtragen, derart, dass die Elektroden (10, 10', 10") sich in einer gemeinsamen Ebene der Verbundscheibe (100) erstrecken und die transparente, elektrisch leitfähige Beschichtung (6) durch zwei beschichtungsfreie Trennlinien (7) in die voneinander elektrisch isolierten Elektroden (10, 10', 10") unterteilt ist, wobei zwei kammförmig ausgebildete Elektroden (10', 10") ineinandergreifen oder zwei kammförmig ausgebildete Elektroden (10', 10") Kammrücken an Kammrücken angeordnet sind, und wobei die zwei kammförmig ausgebildeten Elektroden (10', 10") von einer dritten Elektrode (10) elektrisch unterteilt sind, wobei die dritte Elektrode (10) die beiden kammförmig ausgebildeten Elektroden (10', 10") umfasst und durch eine weitere Trennlinie (Z) von der restlichen transparenten, elektrisch leitfähigen Beschichtung (6) abgetrennt ist, und
- Herstellen einer Stapelfolge aus der Innenscheibe (1), einer Zwischenschicht (2) und einer Außenscheibe (4), wobei die Zwischenschicht (2) zwischen der innenseitigen Oberfläche (II) der Außenscheibe (4) und der außenseitigen Oberfläche (III) der Innenscheibe (1) angeordnet wird, und Laminieren der Stapelfolge zu einer Verbundscheibe (100).

9. Verwendung der Verbundscheibe (100) nach einem der Ansprüche 1 bis 7 in Fortbewegungsmitteln für den Verkehr auf dem Lande, in der Luft oder zu Wasser, insbesondere in Kraftfahrzeugen beispielsweise als Windschutzscheibe oder Heckscheibe.

## Claims

1. Composite pane (100) for separating an interior space from an external environment, comprising
- an inner pane (1), with an outer surface (III) and an inner surface (IV),
- an outer pane (4), with an outer surface (I) and an inner surface (II), and
- an intermediate layer (2) that areally joins the inner surface (II) of the outer pane (2) to the outer surface (III) of the inner pane (1),
- a, in the visible spectral range transparent, electrically conductive coating (6) at least partially or over its entire surface on an inner or outer surface of the inner pane (1), outer pane (4), intermediate layer (2) or in the intermediate layer (2),
- a capacitive sensor (3) for detecting moisture having at least one capacitor (5) that is connected to an electronic sensor unit (14), which is provided for detecting a change in capacitance of the capacitor (5),
wherein the at least one capacitor (5) has three electrodes (10, 10', 10") formed of the transparent, electrically conductive coating (6), which are capacitively coupled, wherein the electrodes (10, 10', 10") extend in a common plane of the composite pane (100) and the transparent, electrically conductive coating (6) is divided by two coating-free separating lines (7) into the electrodes (10, 10', 10") electrically isolated from one another,
wherein two comb-shaped electrodes (10', 10") intermesh or two comb-shaped electrodes (10', 10") are arranged back to back, and
wherein the two comb-shaped electrodes (10', 10") are electrically divided by a third electrode (10), wherein the third electrode (10) comprises both comb-shaped electrodes (10', 10") and is separated by a further separating line (Z) from the rest of the transparent, electrically conductive coating (6).

2. Composite pane (100) according to claim 1, **characterized in that** the electrodes (10, 10', 10") are provided for generating a sensor area on the composite pane, inside which the moisture on the composite pane causes a change in capacitance.

3. Composite pane (100) according to claim 2, **characterized in that** the electronic sensor unit (14) is provided for generating a signal when moisture is detected on the sensor area.

4. Composite pane (100) according to one of claims 1 through 3, **characterized in that** the capacitive sensor (3) includes a plurality of capacitors (5), wherein the electronic sensor unit (14) is provided for generating a plurality of signals and has means for calculating a correlation of the signals.

5. Composite pane (100) according to claim 4, **characterized in that** means of the sensor (3) are provided for calculating an autocorrelation and/or a cross-correlation of the signals.

6. Composite pane (100) according to one of claims 1 through 5, **characterized in that** the electrodes (10, 10', 10") have an asymmetric area.

7. Composite pane (100) according to one of claims 1 through 6, **characterized in that** the electrodes (10, 10', 10") have a different perimeter.

8. Method for producing a composite pane (100) according to one of claims 1 through 7, at least comprising:
- applying a transparent, electrically conductive coating (6) at least partially or over its entire surface on an inner or outer surface of the inner pane (1), outer pane (4), intermediate layer (2) or in the intermediate layer (2) and introducing two separating lines (7), which electrically divide the transparent, electrically conductive coating (6) into three capacitively coupled electrodes (10, 10', 10"), preferably by laser patterning or by mechanical or chemical ablation, such that the electrodes (10, 10', 10") extend in a common plane of the composite pane (100) and the transparent, electrically conductive coating (6) is divided by two coating-free separating lines (7) into the electrodes (10, 10', 10") electrically isolated from one another, wherein two comb-shaped electrodes (10', 10") intermesh or two comb-shaped electrodes (10', 10") are arranged back to back, and wherein the two comb-shaped electrodes (10', 10") are electrically divided by a third electrode (10), wherein the third electrode (10) comprises both comb-shaped electrodes (10', 10") and is separated by a further separating line (Z) from the rest of the transparent, electrically conductive coating (6), and
- producing a stack sequence comprising the inner pane (1), an intermediate layer (2), and an outer pane (4), wherein the intermediate layer (2) is arranged between the inner surface (II) of the outer pane (4) and the outer surface (III) of the inner pane (1), and laminating the stack sequence to form a composite pane (100).

9. Use of the composite pane (100) according to one of claims 1 through 7 in means of transportation for travel on land, in the air, or on water, in particular in motor vehicles, for example, as a windshield or rear window.

## Revendications

1. Vitrage composite (100) destiné à séparer un espace intérieur d'un environnement extérieur, comprenant
- une vitre intérieur (1), avec une surface extérieure (III) et une surface intérieure (IV),
- une vitre extérieur (4), avec une surface extérieure (I) et une surface intérieure (II), et
- une couche intermédiaire (2) qui relie la surface intérieure (II) de la vitre extérieur (4) à la surface extérieure (III) de la vitre intérieur (1),
- un revêtement (6) transparent dans le domaine spectral visible et électriquement conducteur, au moins partiellement ou sur toute sa surface, sur une surface intérieure ou extérieure de la vitre intérieure (1), de la vitre extérieure (4), de la couche intermédiaire (2) ou dans la couche intermédiaire (2),
- un capteur capacitif (3) pour détecter l'humidité, comportant au moins un condensateur (5) qui est relié à une unité de capteur électronique (14) prévue pour détecter une variation de la capacité du condensateur (5),
dans lequel le au moins un condensateur (5) comporte trois électrodes (10, 10', 10") formées à partir du revêtement transparent électriquement conducteur (6), qui sont couplées de manière capacitive,
dans lequel les électrodes (10, 10', 10") s'étendent dans un plan commun du vitrage composite (100) et le revêtement transparent électriquement conducteur (6) est divisé par deux lignes de séparation (7) sans revêtement en électrodes (10, 10', 10") isolées électriquement les unes des autres,
dans lequel deux électrodes en forme de peigne (10', 10") s'engrènent ou deux électrodes en forme de peigne (10', 10") sont disposées dos à dos, et
dans lequel les deux électrodes en forme de peigne (10', 10") sont divisées électriquement par une troisième électrode (10), dans lequel la troisième électrode (10) comprend les deux électrodes en forme de peigne (10', 10") et est séparée par une autre ligne de séparation (Z) du reste du revêtement transparent électriquement conducteur (6).

2. Vitrage composite (100) selon la revendication 1, **caractérisé en ce que** les électrodes (10, 10', 10") sont prévues pour générer une zone de détection sur le vitrage composite, à l'intérieur de laquelle l'humidité présente sur le vitrage composite provoque une variation de capacité.

3. Vitrage composite (100) selon la revendication 2, **caractérisé en ce que** l'unité de capteur électronique (14) est prévue pour générer un signal lorsque de l'humidité est détectée sur la zone de détection.

4. Vitrage composite (100) selon l'une des revendications 1 à 3, **caractérisé en ce que** le capteur capacitif (3) comprend une pluralité de condensateurs (5), dans lequel l'unité de capteur électronique (14) est prévue pour générer une pluralité de signaux et comporte des moyens pour calculer une corrélation des signaux.

5. Vitrage composite (100) selon la revendication 4, **caractérisé en ce que** des moyens du capteur (3) sont prévus pour calculer une autocorrélation et/ou une corrélation croisée des signaux.

6. Vitrage composite (100) selon l'une des revendications 1 à 5, **caractérisé en ce que** les électrodes (10, 10', 10") ont une surface asymétrique.

7. Vitrage composite (100) selon l'une des revendications 1 à 6, **caractérisé en ce que** les électrodes (10, 10', 10") ont un périmètre différent.

8. Procédé de fabrication d'un vitrage composite (100) selon l'une des revendications 1 à 7, comprenant au moins:
- l'application d'un revêtement transparent électriquement conducteur (6) au moins partiellement ou sur toute sa surface sur une surface intérieure ou extérieure de la vitre intérieure (1), de la vitre extérieure (4), de la couche intermédiaire (2) ou dans la couche intermédiaire (2) et l'introduction de deux lignes de séparation (7) qui divisent électriquement le revêtement transparent électriquement conducteur (6) en trois électrodes couplées capacitivement (10, 10', 10"), de préférence par structuration au laser ou par ablation mécanique ou chimique, de telle sorte que les électrodes (10, 10', 10") s'étendent dans un plan commun du vitrage composite (100) et que le revêtement transparent électriquement conducteur (6) soit divisé par deux lignes de séparation (7) sans revêtement en électrodes (10, 10', 10") isolées électriquement les unes des autres, dans lequel deux électrodes en forme de peigne (10', 10") s'imbriquent ou deux électrodes en forme de peigne (10', 10") sont disposées dos à dos, et dans lequel les deux électrodes en forme de peigne (10', 10") sont divisées électriquement par une troisième électrode (10), dans lequel la troisième électrode (10) comprend les deux électrodes en forme de peigne (10', 10") et est séparée par une autre ligne de séparation (Z) du reste du revêtement transparent électriquement conducteur (6), et
- produire une séquence d'empilement comprenant la vitre intérieure (1), une couche intermédiaire (2) et une vitre extérieure (4), dans laquelle la couche intermédiaire (2) est disposée entre la surface intérieure (II) de la vitre extérieure (4) et la surface extérieure (III) de la vitre intérieure (1), et laminer la séquence d'empilement pour former un vitrage composite (100).

9. Utilisation du vitrage composite (100) selon l'une des revendications 1 à 7 dans des moyens de transport terrestres, aériens ou aquatiques, en particulier dans des véhicules à moteur, par exemple comme pare-brise ou lunette arrière.
